# EUROPÄISCHE PATENTSCHRIFT

(11) **EP 0 803 587 B1**
(45) Veröffentlichungstag und Bekanntmachung des Hinweises auf die Patenterteilung: **04.10.2000**
(21) Anmeldenummer: 97112040.7
(22) Anmeldetag: 15.07.1997
(51) Int. Cl.: C23C 14/00, C23C 14/34, H01J 37/34

(54) **Verfahren und Vorrichtung zur Sputterbeschichtung**
Method and apparatus for sputter coating
Procédé et appareillage de dépôt par pulvérisation cathodique

(43) Veröffentlichungstag der Anmeldung: 29.10.1997
(73) Patentinhaber: Unaxis Trading AG, 9477 Trübbach (CH)
(72) Erfinder: Haag, Walter, 9472 Grabs (CH); Gruenenfelder, Pius, 7323 Wangs (CH)
(74) Vertreter: Troesch Scheidegger Werner AG

(56) Entgegenhaltungen:
- DE-A- 4 422 472
- US-A- 3 830 721
- US-A- 3 922 214
- US-A- 4 094 764
- PATENT ABSTRACTS OF JAPAN vol. 015, no. 436 (C-0882), 7.November 1991 & JP 03 183760 A (TOYOBO CO LTD), 9.August 1991,
- PATENT ABSTRACTS OF JAPAN vol. 012, no. 451 (P-791), 28.November 1988 & JP 63 174120 A (FUJITSU LTD), 18.Juli 1988,

## Beschreibung

Die vorliegende Erfindung betrifft ein Verfahren zum Sputterbeschichten von Werkstücken, bei dem zwei sich gegenüberliegende Zerstäubungsflächen gegeneinander zerstäubt werden und zwischen den Zerstäubungsflächen eine Gasströmung erstellt und gegen mindestens ein Werkstück gerichtet wird. Im weiteren bezieht sich die vorliegende Erfindung auf eine Sputterbeschichtungsquelle mit zwei sich gegenüberliegenden Zerstäubungsflächen, einer zwischen den Zerstäubungsflächen vorgesehenen Anodenanordnung und einer in einem zwischen den Zerstäubungsflächen definierten Spalt wirkenden Gasauslassanordnung, entsprechend den Oberbegriffen der Ansprüche 1 bzw. 15. Im weiteren bezieht sich die vorliegende Erfindung auf eine Sputterbeschichtungsanlage mit einer derartigen Quelle gemäss Anspruch 24 sowie Verwendungen des erfindungsgemässen Verfahrens, der erfindungsgemässen Quelle bzw. der erfindungsgemässen Anlage gemäss den Ansprüchen 26-28.

Aus der US 4 094 764 ist es bekannt, für das Sputterbeschichten eines Werkstückes eine Gasströmung über der Zerstäubungsfläche zu realisieren, um das strömende Inert- bzw. Edel-Gas mit abgestäubtem Targetmaterial gegen das Werkstück zu treiben. Damit werde, verglichen mit herkömmlichem, kathodischen Sputtern, eine wesentlich höhere Beschichtungsrate erzielt.

Ganz ähnlich wird gemäss der DE-PS 42 10 125 vorgegangen, indem eine Gasströmung nicht über die Zerstäubungsflächen eines Flachtargets gemäss der US-A 4 094 764, sondern entlang der Innenfläche eines hohlkegelförmigen Targets - einem Hohlkathodentarget - erstellt wird und das vom Target abgestäubte Material mittels der Strömung einem Substratwerkstück zugeführt wird.

In H. Koch et al. "Hollow cathode discharge sputtering device for uniform large area thin film deposition", J. Vac. Sci. Technol. A9(4), Jul/Aug 1991, sind die Vorteile von solchen Hohlkathodensputtern erörtert, insbesondere bezüglich Ausnützung der Elektronen für die Ionisation des im Reaktionsvolumen enthaltenen Gases. Es wird deshalb dort vorgeschlagen, in einem Targetblock einen Querschlitz vorzusehen und eine Gasströmung durch diesen Schlitz gegen ein Werkstück hin gerichtet einzusetzen.

Am Schlitz liegen sich zwei Zerstäubungsflächen des Targets nahe gegenüber, was die unerwünschte Wiederbelegung anderer Anlageteile als den Targets selber minimiert.

Dies ist insbesondere von Bedeutung bei reaktivem DC Sputtern, bei dem elektrisch isolierende Reaktionsprodukte als Beschichtungsmaterial erzeugt und rückbelegt werden.

Dieses Vorgehen weist aber folgenden Nachteil auf:

Soll die Belegung der sich gegenüberliegenden Zerstäubungsflächen mit bereits reagiertem Targetmaterial minimalisiert und der Elektronenstosswirkungsgrad für die Ionisation maximiert werden, so muss die gewählte Spaltbreite und damit der Abstand zwischen den beiden Zerstäubungsflächen klein gehalten werden. Die Ausbildung des Spaltes mit nahe gegenüberliegenden Zerstäubungsflächen bedingt aber entsprechend kurze Spaltbreiten- bzw. Abschluss-Flächen. Dies wiederum ist bezüglich der Elektronenstossausbeute äusserst nachteilig, indem sie in den SchlitzEndbereichen reflektiert werden und schliesslich, ohne ihre Energie durch die Stosskaskade an die Gasteilchen vollständig abzugeben, teilweise nicht voll genutzt über die Anode abgeführt werden. Es bestehen mithin beim Einsatz einer Schlitzhohlkathode der im obgenannten Artikel dargestellten Art grundsätzlich das Problem, dass, je besser das Targetbelegungsproblem entlang den Zerstäubungsflächen gelöst wird, nämlich mit möglichst geringer Schlitzbreite, desto höher wird der Verlust an Elektronenstossausbeute in den Schlitzendbereichen. In der Regel besteht in Längsrichtung des Schlitzes eine Elektronendrift, bevorzugt gegen ein Schlitzende hin, was zu einer ungleichmässigen Plasma-Längsverteilung und somit Abstäub-Verteilung führt.

Die vorliegende Erfindung setzt sich zum Ziel, die obgenannten Probleme zu lösen. Dies wird ausgehend vom Verfahren obgenannter Art dadurch erreicht, dass die sich gegenüberliegenden Zerstäubungsflächen je in sich geschlossen werden und die Gasströmung durch einen in sich geschlossenen Spalt, im wesentlichen quer zu Schnittebenen erzeugt wird, in denen der Spalt in sich geschlossen erscheint, womit eine geschlossene Plasmaschlaufe entsteht.

Dadurch, dass der Spalt in sich geschlossen ist, realisiert durch zwei sich gegenüberliegende, je in sich geschlossene Zerstäubungsflächen, beispielsweise eines Innenzylindertargets und eines Aussenzylinderhohltargets, wird erreicht, dass in weiten Grenzen die Spaltbreite dimensioniert und insbesondere kurz ausgebildet werden kann, um insbesondere den erwähnten Rückbelegungsproblemen Rechnung zu tragen, dass aber trotzdem, dank der in sich geschlossenen Zerstäubungsflächen, auch wenn gegebenenfalls daran Ecken vorgesehen sind, wie bei Einsatz von Quadertargets, keine Spalt-Enden am umlaufenden Spalt vorliegen und damit die Elektronen, die sich entlang und innerhalb der Plasmaschlaufe bewegen, solange darin umlaufen können, bis sie ihre Energie durch Stösse an die Gasteilchen möglichst vollständig abgegeben haben, was zu einer effizienteren Plasma-Entladung führt. Dies ist ersichtlich aus den tieferen Entladespannungen und dem stabileren Betrieb.

Wird, wie bevorzugterweise vorgeschlagen, jede der in sich geschlossenen Zerstäubungsflächen an einem eigenen Target gebildet, so ergibt sich im weiteren eine bevorzugt stabile Anordnung. Jedes der vorgesehenen Targets kann auch mit einer separaten Generator-Anordnung gespiesen werden, um optimalen Leistungsabgleich zu erzielen, oder um mit unterschiedlichen Targetmaterialien Mischmaterialien zu erzeugen.

Insbesondere aufgrund der hohen Plasmadichte im umlaufenden Spalt ist es möglich, das Rückbelegungsproblem der Zerstäubungsflächen, insbesondere mit elektrisch isolierenden Reaktionsprodukten, beim Reaktivzerstäuben weiter zu minimalisieren, womit sich das vorgeschlagene Vorgehen insbesondere für das Beschichten mit dielektrischen Materialien, dabei insbesondere mit Oxiden, eignet. Deshalb wird auch in einer bevorzugten Ausführungsform mindestens ein Gasanteil als Reaktivgas gewählt, vorzugsweise mit O₂, wobei eine gute Gastrennung sichergestellt wird, wenn das Inertgas, z.B. Ar, in den Spalt eingelassen wird, und das Reaktivgas, vom Target entfernt, in die Kammer.

Reaktivgas wird weitaus bevorzugt nicht durch den Spalt eingelassen, sondern direkt in den Beschichtungsraum.

In einer besonders bevorzugten Ausführungsform erfolgt die Beschichtung mit einem Material mit mindestens einer ferromagnetischen Komponente oder mit einem dielektrischen Material, beide Beschichtungsmaterialien bekanntlich für das auch hier bevorzugte DC Sputtern äusserst kritisch. In einer weiteren bevorzugten Ausführungsform wird die Beschichtung mit MgO oder ITO vorgenommen, sei dies durch reaktives Sputtern metallischer Targets oder durch gegebenenfalls zusätzlich reaktives Sputtern oxydischer Targets, also insbesondere, wie bei MgO, von Materialien, die aufgrund ihrer extrem tiefen Leitfähigkeit für DC Sputtern äusserst problematisch sind.

Mit dem erfindungsgemässen Vorgehen und aufgrund der Tatsache, dass die beiden sich gegenüberliegenden Zerstäubungsflächen je an einem Target realisiert werden können, ergibt sich auch die Möglichkeit, für die beiden Zerstäubungsflächen unterschiedliche Materialien einzusetzen und damit komplexere Beschichtungsmaterialien insbesondere reaktiv abzulegen.

In einer besonders bevorzugten Ausführungsform wird im Spalt ein Magnetfeld erzeugt, bevorzugterweise in der Art eines Magnetronfeldes, indem an mindestens einem, vorzugsweise entlang beider Zerstäubungsflächen, mindestens ein Magnetfeld mit tunnelförmigem Feldlinienverlauf erzeugt wird, wobei die Tunnelachsen entlang der in sich geschlossenen Sputterflächen verlaufen und sich vorzugsweise ebenfalls schliessen.

Wird bereits mit dem erfindungsgemässen Vorsehen eines in sich geschlossenen, umlaufenden Spaltes gegenüber Schlitztargets, wie im obgenannten Artikel erwähnt, eine wesentliche Erhöhung der Plasmadichte erzielt, so wird diese Plasmadichte mit Vorsehen der erwähnten Magnetfelder noch weiter erhöht. Dies u.a. aufgrund der zunehmend verbesserten Elektronenstossausbeute (kontinuierlich umlaufende Elektronenfallen).

Obwohl es durchaus möglich ist, das oder die Targets beim erfindungsgemässen Vorgehen mit AC zu betreiben, wird, vor allen aus Kostengründen, in einer weitaus bevorzugten Realisationsform DC eingesetzt, gegebenenfalls, wie im Pulsbetrieb, mit überlagertem AC, um den Betrieb besonders stabil zu führen.

Eine Sputterbeschichtungsquelle zur Lösung der obgenannten Aufgabe zeichnet sich dadurch aus, dass die Zerstäubungsflächen je in sich geschlossene Flächen bilden, der Spalt ein in sich geschlossener, mindestens einseitig offener Spalt ist und die Gasauslassanordnung der Spaltöffnung gegenüberliegend vorgesehen ist.

Eine erfindungsgemässe Sputterbeschichtungsanlage weist mindestens eine Sputterbeschichtungsquelle der genannten Art auf sowie für das mindestens eine Target, vorzugsweise die mindestens zwei Targets, einen DC-Generator, gegebenenfalls eine Generatoranordnung zur Abgabe eines DC-Signals mit überlagertem AC-Signal, dabei vorzugsweise eines gepulsten DC-Signals.

Das erfindungsgemässe Verfahren, die erfindungsgemässe Quelle sowie die erfindungsgemässe Anlage eignen sich insbesondere zum Sputterbeschichten mit ferromagnetischen Materialien oder dielektrischen Materialien, dabei insbesondere für MgO- bzw. ITO-Beschichtungen bzw. für das Beschichten von Plasma Display Panels, wo grosse Flächen wirtschaftlich beschichtet werden müssen.

In diesem Fall können die Substrate z.B. über die lineare Quellenanordnung hinweggeführt werden. Es ist auch möglich, mehrere lineare Quellen in für die Verteilung geeigneten Abständen so anzuordnen, um die Gesamtbeschichtungsrate zu erhöhen oder grossflächig, statisch zu beschichten.

Bevorzugte Ausführungsformen des erfindungsgemässen Verfahrens sind in den Ansprüchen 2 bis 14 spezifiziert, der erfindungsgemässen Quelle in den Ansprüchen 16 bis 23 und der erfindungsgemässen Anlage in den Ansprüchen 24 und 25.

Besonders bevorzugte Verwendungen der Erfindung sind in den Ansprüchen 26 bis 28 spezifiziert.

Die Erfindung wird anschliessend beispielsweise anhand von Figuren erläutert. Diese zeigen:
- Fig. 1:: Perspektivisch und schematisch einen Querschnitt durch eine erfindungsgemässe Sputterquelle, nach dem erfindungsgemässen Verfahren arbeitend;
- Fig. 2:: ausgehend von der Darstellung nach Fig. 1, eine weitere Variante zur elektrischen Speisung der erwähnten Quelle;
- Fig. 3:: eine schematische Querschnittsdarstellung einer weiteren Zerstäubungsflächenanordnung nach dem erfindungsgemässen Verfahren bzw. an einer erfindungsgemässen Quelle bzw. Anlage;
- Fig. 4 bis 8:: weitere perspektivisch dargestellte Anordnungen von Zerstäubungsflächen bzw. Targets bei erfindungsgemässem Vorgehen;
- Fig. 9:: schematisch eine erfindungsgemässe Sputterquelle, nach dem erfindungsgemässen Verfahren arbeitend und an einer erfindungsgemässen Anlage eingesetzt mit grundsätzlich bevorzugt eingesetztem Magnetfeld;
- Fig. 10:: ausgehend von der Darstellung nach Fig. 9 eine weitere Ausbildung des bevorzugt eingesetzten Magnetfeldes;
- Fig. 11:: eine weitere Ausbildung eines bevorzugt eingesetzten Magnetfeldes;
- Fig. 12:: über der pro Zerstäubungsflächeneinheit abgetragenen Leistung die DC-Plasma-Entladungsspannung (a) bei Vorgehen nach dem Stand der Technik,
(b) bei erfindungsgemässem Vorgehen ohne Magnetfeld,
(c) bei erfindungsgemässem Vorgehen mit Magnetfeld und

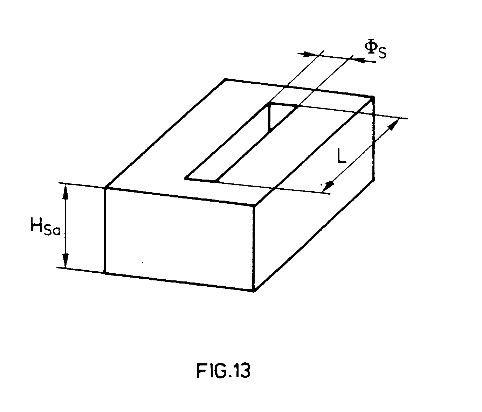

- Fig. 13:: ein Schlitztarget bekannter Bauweise mit Definition seiner geometrischen Grössen.

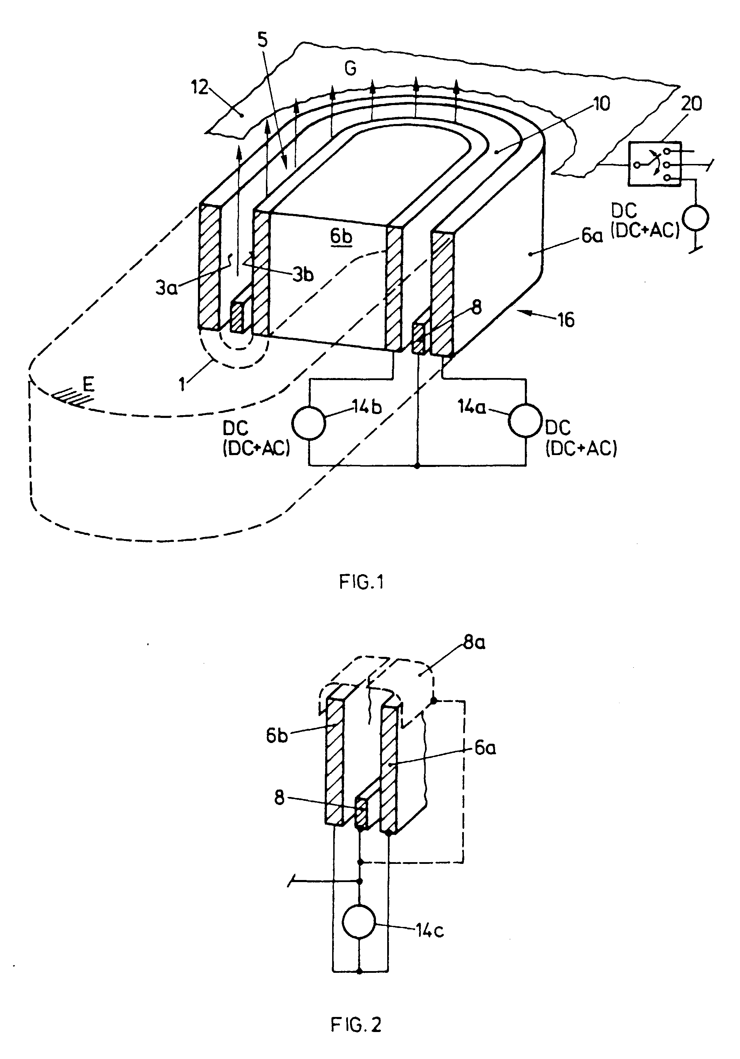

Anhand von Fig. 1 soll das grundsätzliche erfindungsgemässe Vorgehen erläutert werden.

Es werden zwei in sich geschlossene Zerstäubungsflächen 3a und 3b so vorgesehen, dass sie zwischen sich einen an einer umlaufenden Öffnung 10 mindestens einseitig offenen, in sich geschlossen umlaufenden Spalt 5 definieren. Die Zerstäubungsflächen 3a bzw. 3b können dabei, wie gestrichelt bei 1 dargestellt, durch Einarbeiten des Spaltes 5 in einen einheitlichen Targetblock ausgebildet sein, bevorzugterweise sind aber die Zerstäubungsflächen 3a und 3b Zerstäubungsflächen je eines Targets, nämlich eines Aussentargets 6a und eines Rundum- bzw. im wesentlichen Stab-Targets 6b.

Am einen Endbereich des Spaltes 5 ist eine Anodenanordnung 8 vorgesehen, die, wie dargestellt, aus einer gemeinsamen Anode für beide Targets 6a bzw. 6b ausgebildet sein kann, gegebenenfalls aber auch zwei separat speisbare Anodenringe umfassen kann. Die Anode kann aber auch mit Vorteil an der Austrittsseite (10) plaziert sein und gleichzeitig die Kathode von aussen mit Dunkelraumabstand umschliessen, oder aber auch isoliert montiert sein. Sie kann auch gleichzeitig als Schlitzblende ausgebildet sein. Anoden werden bevorzugt auf Masse betrieben. Biaseinspeisung zur Steuerung der Teilchenenergie ist auch möglich. Eine solche Anodenanordnung ist in Fig. 2 gestrichelt bei 8a dargestellt.

Es wird eine Gasströmung G entlang des Spaltes 5 erzeugt, und zwar im wesentlichen quer zur Schnittfläche, wie beispielsweise E, worin der Spalt 5 als geschlossen umlaufend erscheint. Mit der Gasströmung G werden Beschichtungspartikel aus dem Spalt 5 durch die Spaltöffnung 10 gegen ein oder mehrere Werkstücke 12 getragen und dort sanft abgelegt. Bei Reaktivsputtern wird ein Reaktivgas auch erst dort eingelassen.

Das eine oder, wie dargestellt, die beiden, die Zerstäubungsflächen 3a und 3b definierenden Targets 6a, 6b werden vorzugsweise je einzeln DC oder gegebenenfalls mit DC und überlagertem AC gespiesen, je von einem zugeordneten Generator 14a bzw. 14b. Alternativ werden sie gegebenenfalls, wie in Fig. 2 dargestellt, durch einen gemeinsamen Generator 14c gespiesen.

Das Werkstück 12 bzw. ein an der erfindungsgemässen Anlage hierfür vorgesehener Werkstückträger (nicht dargestellt) wird, in einer Vakuumkammer der erfindungsgemässen Sputteranlage mit der eben beschriebenen Quelle 16, potential-schwebend oder auf Bezugspotential, wie Masse, oder auf einem Biaspotential, vorzugsweise DC-Potential, oder einem DC-Potential mit überlagertem AC-Potential gehalten, wie dies schematisch in Fig. 1 mit dem Möglichkeitenschalter 20 dargestellt ist.

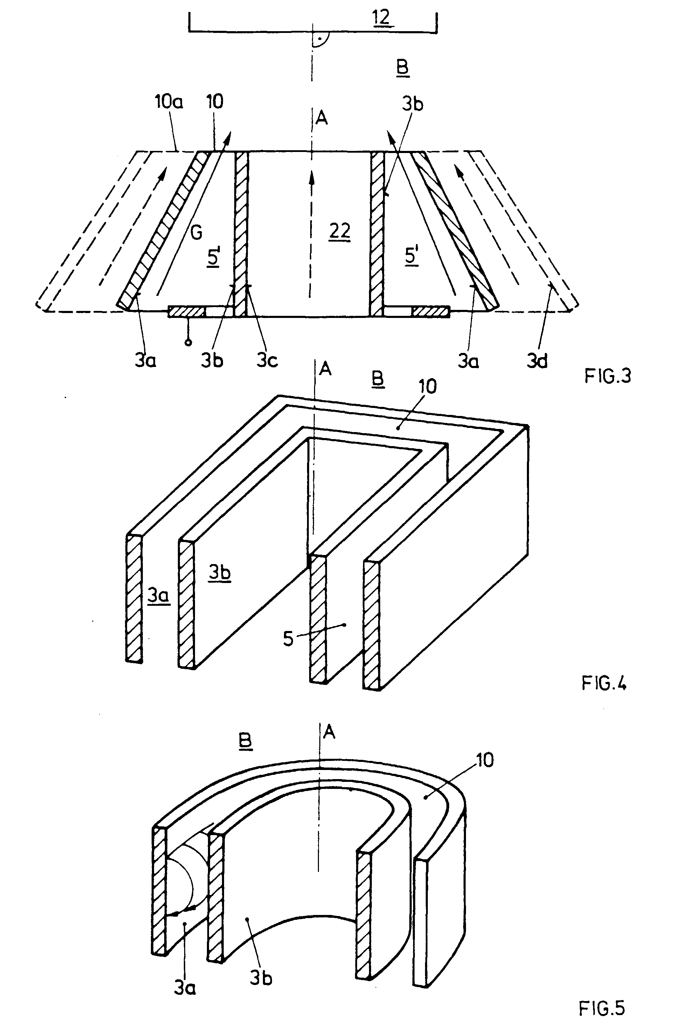

In Fig. 3 ist in Querschnittsdarstellung schematisch eine weitere Anordnung der Zerstäubungsflächen 3a bzw. 3b gemäss Fig. 1 dargestellt. Hierbei verjüngt sich der Spalt 5' gegen die Gasaustrittsöffnung 10 hin, womit druckstufenähnlich eine beschleunigte Gasströmung G gegen das Werkstück 12 erzielt wird. Wie gestrichelt in Fig. 3 weiter dargestellt, lässt sich das anhand von Fig. 1 dargestellte, der vorliegenden Erfindung zugrundeliegende Prinzip insofern erweitern, als auch der Innenraum 22 gegebenenfalls mit einer zusätzlichen Zerstäubungsfläche 3c beschichtungswirksam - als Hohlkathode - ausgenützt werden kann und/oder durch Vorsehen weiterer Zerstäubungsflächen 3d und entsprechend zusätzlich umlaufender Spalten 10a eine zunehmend komplexere erfindungsgemässe Quelle platzsparend realisiert werden kann.

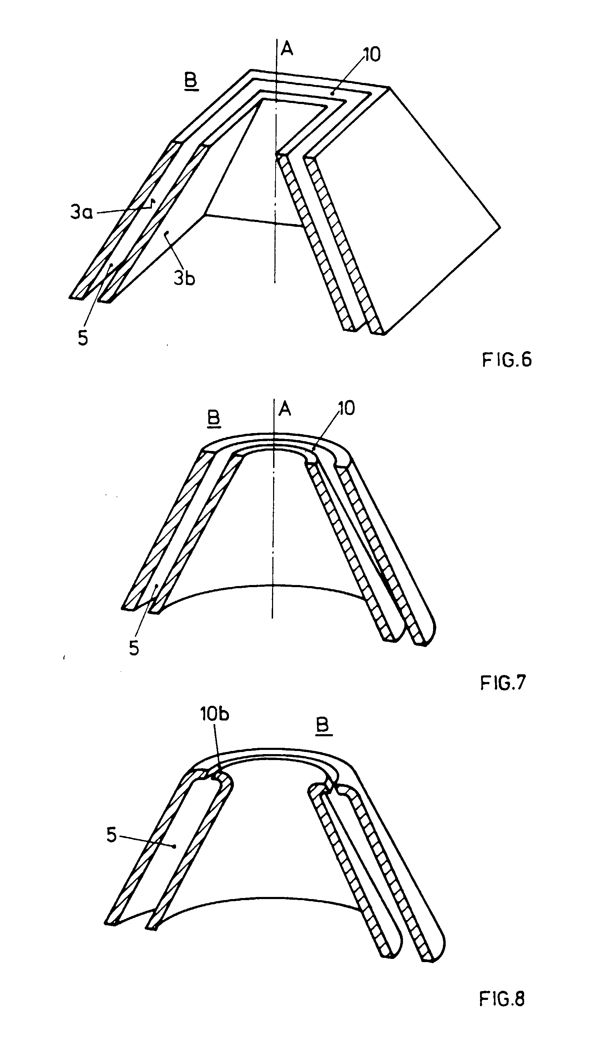

Ohne in den Fig. 4 bis 8 weitere Details, ausser der Anordnung der Zerstäubungsflächen und, entsprechend, der Ausbildung des einen oder der zwei in Minimalkonfiguration vorgesehenen Targets darzustellen, zeigen diese Figuren verschiedene Ausformungsvarianten des umlaufenden Spaltes 10 und damit der diesen definierenden, ebenfalls umlaufenden Zerstäubungsflächen 3a bzw. 3b.

In Fig. 4 ist der umlaufende Spalt 10 in Aufsicht rechteckig rahmenförmig, gemäss Fig. 5 kreisringförmig oder elliptisch, wobei die den Spalt definierenden Zerstäubungsflächen in den Fig. 4 und 5 parallel zu einer Zentrumsachse A und äquidistant sind. Es spannen die Zerstäubungsflächen gemäss den Fig. 4 bzw. 5 nämlich Quaderflächen bzw. Zylinderflächen oder zylinderähnliche Flächen 3a, 3b auf.

Bei der Anordnung gemäss Fig. 6 spannen die Sputterflächen 3a, 3b Pyramidenstumpf-Flächen auf, gemäss Fig. 7 im wesentlichen kreiskegel- oder ellipsoidkegelförmige Flächen auf.

Gemäss den Fig. 6, 7 und 8 reduziert sich, trotz äquidistanten Zerstäubungsflächen, der Gasströmungsquerschnitt des Spaltes gegen die Öffnung 10 hin, noch ausgeprägter bei Ausbildung nach Fig. 3. Damit ergibt sich einerseits ein zunehmend intensiver Kontakt Gasströmung mit den Zerstäubungsflächen sowie eine Gasströmungs-Beschleunigung hin gegen das Werkstück. Dieser Effekt kann - wie erwähnt wird mit Blick auf Fig. 3 - bei allen Ausführungsformen gemäss den Figuren 4 bis 8 dadurch erhöht werden, dass die Zerstäubungsflächen nicht äquidistant angeordnet werden, sondern sich gegen die Auslassöffnung 10 hin, vorzugsweise stetig, nähernd. Bei der Ausführungsform gemäss Fig. 8, die von derjenigen von Fig. 7 ausgeht, ist als Beispiel dargestellt, wie bei allen Ausführungsvarianten eine ausgeprägte Druckstufe zwischen Spalt 5 und Werkstückbeschichtungsraum B realisiert werden kann, mit entsprechender Erhöhung der Gasausströmungs-Geschwindigkeit hin zu dem in Fig. 3 dargestellten Werkstück 12.

Anhand der Fig. 1 bis 8 ist dem Fachmann zweifelsfrei klar, wie prinzipiell und erfindungsgemäss die Zerstäubungsflächen auszubilden und anzuordnen sind, und es eröffnen sich ihm damit weitere Möglichkeiten zur Gaseinsparung bzw. noch besseren Trennung von Inertgas und Reaktivgas.

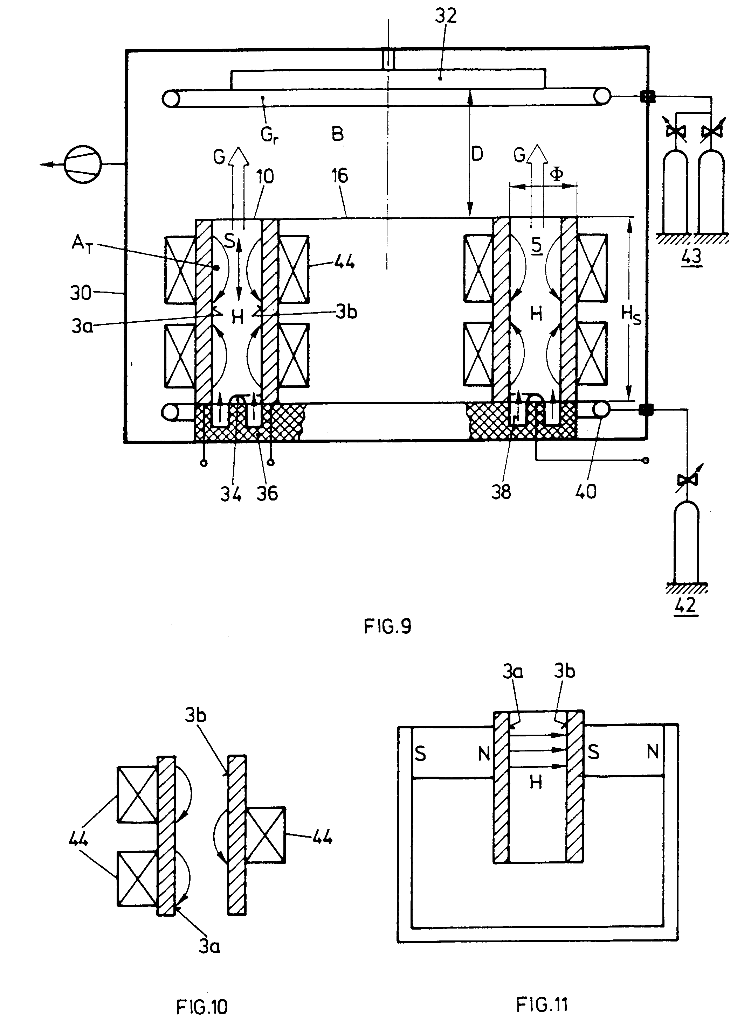

In Fig. 9 ist eine Querschnittsdarstellung einer erfindungsgemässen Anlage mit erfindungemässer Sputterquelle, die nach dem erfindungsgemässen Verfahren arbeitet, dargestellt, wobei weitere, höchst bevorzugt eingesetzte Massnahmen daran beschrieben werden sollen, die selbstverständlich an allen bisher beschriebenen Ausführungsformen der Erfindung bevorzugt auch realisiert werden.

Gemäss Fig. 9 ist in einer Behandlungskammer 30 einer erfindungsgemässen Anlage eine erfindungsgemässe Quelle 16 vorgesehen. Sie liegt einem schematisch dargestellten Werkstückträger 32 gegenüber. Sie kann ausgebildet sein nach einer der verschiedenen, anhand der Fig. 1 bis 8 dargestellten Varianten. Der der Gasauslassöffnung 10 des Spaltes 5 gegenüberliegende Spaltbereich ist verschlossen und trägt einen umlaufenden Anodenring 34. Im Spaltabschluss 36 ist ein Gasverteilraum 38 vorgesehen, welcher beispielsweise mittels einer umlaufenden Ringleitung 40 von einer Gastankanordnung 42 gespiesen wird, welche vorzugsweise ein Inertgas, wie ein Edelgas, beispielsweise Ar, enthält.

Zusätzlich, und als in allen Varianten gemäss den Figuren 1 bis 8 dargestellten Ausführungsformen bevorzugte Variante, wird im Spalt 5 ein Magnetfeld H erzeugt. Es sind Permanent- und/oder Elektromagnetanordnungen 44 vorgesehen, die an mindestens einem, wie dargestellt an beiden, Zerstäubungsflächen 3a bzw. 3b weitaus bevorzugt tunnelförmig ein- und austretende H-Feldlinien erzeugen, wobei die Tunnelachsen, wie bei A_{T} in Fig. 9 dargestellt, entlang den umlaufenden, in sich geschlossenen Zerstäubungsflächen ebenfalls umlaufen und vorzugsweise auch in sich geschlossen sind.

In Fig. 10 ist eine andere Anordnung der Tunnel-Magnetfelder und mithin der Magnetordnungen 44 dargestellt, woraus für den Fachmann ersichtlich ist, dass je nach Spaltausdehnung und angestrebter Wirkung die bevorzugt eingesetzten Tunnelfelder an den beiden Zerstäubungsflächen verschieden, wie beispielsweise in Fig. 10 dargestellt, örtlich gestaffelt realisiert werden können. Geeignet vor allem für ferromagnetische Targets sind auch homogene Felder von Target zu Target, welche z.B. durch Jochanordnungen gemäss Fig. 11 erreicht werden, oder Mischformen homogener und inhomogener Felder.

Das erfindungsgemässe Verfahren bzw. die Quelle bzw. Anlage hierfür sind insbesondere geeignet zum Sputterbeschichten von Werkstücken mit Materialien, die mindestens einen ferromagnetischen Anteil aufweisen oder mit dielektrischen Materialien. Mithin ist mindestens eine, vorzugsweise sind beide Zerstäubungsflächen und mithin die zugeordneten Targets vorzugsweise aus einem ferromagnetischen Material oder aus einem dielektrischen Material gebildet, falls letzteres nicht reaktiv gebildet und abgelegt wird. Insbesondere für das Ablegen dielektrischer Schichten wird zusätzlich oder anstelle des Vorsehens dielektrischer Targets das Gas Gᵣ oder mindestens eine Komponente dieses Gases durch ein Reaktivgas aus der Tankanordnung 43 gebildet sein, zusätzlich zum Inertgas G aus Tankanordnung 42. So kann beispielsweise und in der besonders bevorzugten Anwendung eine MgO-Schicht abgelegt werden, sei dies durch Sputtern von MgO-Targets, gegebenenfalls mit nachträglicher Nachoxydation in einem O₂ enthaltenden Gas Gᵣ, oder durch Sputtern aus metallischen Mg-Targets und Reaktion mit dem O₂ enthaltenden Gas Gᵣ. Insbesondere die Ausbildung der Quelle als Kreisquelle ermöglicht es, kreisförmige Substratscheiben sputterzubeschichten, wie beispielsweise Speicherscheiben aller bekannten Gattungen, wobei sich die Erfindung bei linearer Ausbildung insbesondere eignet für die Herstellung von PDP, sogenannter Plasma Display Panels.

Für den Betrieb einer erfindungsgemässen Quelle werden folgende Parameter angeraten:
Totaldruck im Beschichtungsraum B: 0,1 bis 10 mbar

Für reaktives Sputtern von Oxyden:
Partialdruck O₂: bis 10 % vom Totaldruck im Beschichtungsraum B mit Einlass von 0₂ (Gᵣ) in Raum B.

Austrittsströmung des Gases G aus der Öffnung 10 in den Behandlungsraum B:

Die Ar-Gasströmung G im Spalt wird im knudsenschen oder viskosen Bereich realisiert. Dabei gilt
Knudsenscher Bereich:
   10⁻² mbar cm ≤ p· Φ ≤ 0,6 mbar · cm
Viskoser Bereich:
   0,6 mbar cm < p· Φ,
mit p als Totaldruck im Spalt und Φ (siehe Fig. 9) als Spaltbreite.

Vorzugsweise wird die Gasströmung im knudsenschen Bereich gewählt. Weiter gilt vorzugsweise:
10 sccm/cm² ≤ F ≤ 200 sccm/ cm²,
mit F als Arbeits- und gegebenenfalls Reaktivgasfluss pro Spaltöffnungs-Flächeneinheit,
vorzugsweise 20 sccm/cm² ≤ F ≤ 50 sccm/ cm².

Spaltbreite bzw. Targetabstand Φ (siehe Fig. 9):
5 mm ≤ Φ ≤ 40 mm,
vorzugsweise Φ ≤ 25mm
vorzugsweise 8 mm ≤ Φ ≤ 20 mm.

Spalthöhe H_{S} (siehe Fig. 9):
1 cm ≤ H_{S} ≤ 20 cm.

Magnetfeld: Gemessen parallel zu den Zerstäubungsflächen in der Mitte des Spaltes 5:
150 Gauss ≤ H ≤ 1200 Gauss,
vorzugsweise H ≥ 300 Gauss,
vorzugsweise 300 Gauss ≤ H ≤ 800 Gauss.

Eine erfindungsgemässe Anlage mit Rundquelle, aufgebaut im wesentlichen gemäss Fig. 9, weist folgende Dimensionierung auf und wurde wie folgt betrieben:
- Abstand Öffnungs-Ebene zu Substrat (D, Fig. 9): 40 mm
- gesamte Targetfläche: 301,4 cm²
- Spalthöhe H_{S}: 40 mm
- Spaltbreite φ: 30 mm
- Austrittsfläche 10: 113 cm²
- mittlerer Spaltdurchmesser: 120 mm
- Spaltlänge: 377 mm
- Argon-Fluss: 2825 sccm
- Druck im Beschichtungsraum B: 0,6 mbar
- Leistung: 9 kW
- Leistung pro Targetflächeneinheit: 29,9 W/cm²
- Argonfluss pro Austrittsflächeneinheit: 25 sccm/cm²
- Feldstärke H, parallel zu Zerstäubungsfläche, am Target: 300 Gauss

Resultat:
Al-Beschichtungsrate: 22 Å kWs
Fe-Beschichtungsrate: 16 Å kWs
MgO-Beschichtungsrate (Mg-Target mit O₂-Anteil in B ca. 2 %): 18 Å kWs

Durch die Erhöhung des Gasflusses kann die Beschichtungsrate um einen Faktor von 2 bis 3 weiter erhöht werden.

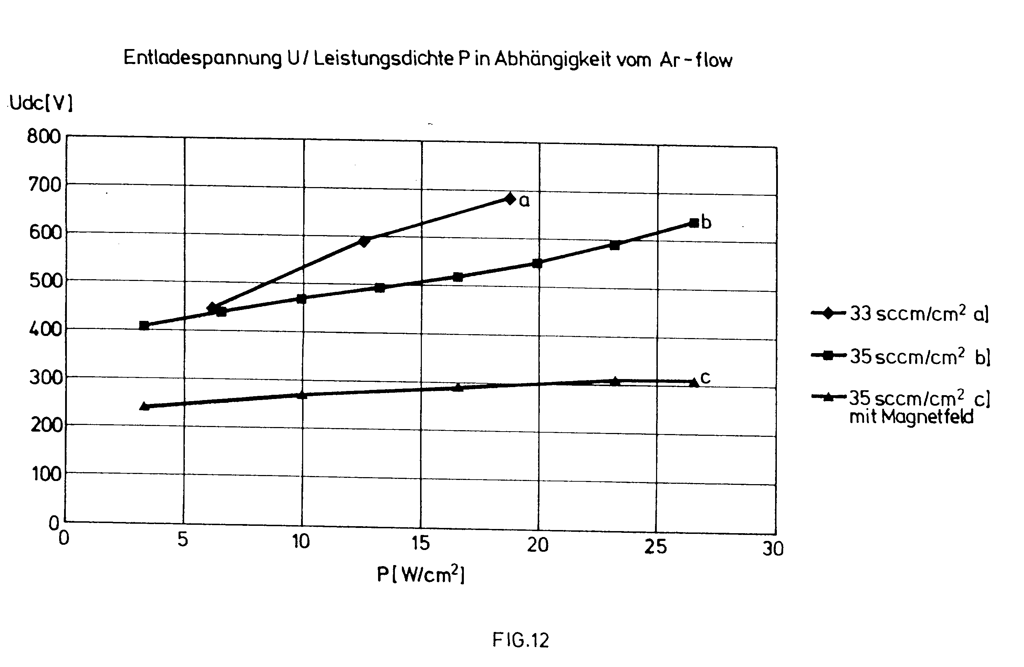

In Fig. 12 ist die Abhängigkeit der Entladungsleistung P von der DC-Brennspannung U dargestellt.
(a) stellt den Verlauf an einem Al-Schlitztarget gemäss oben erwähntem Artikel H. Koch et al. dar mit folgender Schlitzdimension (s. Fig. 12):
   Schlitzlänge L: 10 cm
   Schlitzbreite Φ_{S}: 30 mm
   Schlitzhöhe H_{Sa}: 40 mm

   Ar-Fluss:
   Gasfluss in Beschichtungsraum pro
   Schlitzflächeneinheit: 33 sccm/cm²
   Totaldruck im Beschichtungsraum B: 0,6 mbar
(b): Betrieb und Dimensionierung der erfindungsgemässen Anlage, wie oben spezifiziert, aber ohne Magnetfeld H und mit einem Argon-Fluss G pro Öffnungsflächeneinheit von 35 sccm/cm².
- (c) an die wie unter (b) betriebene Anlage wurde anschliessend im Spalt 10 an jedem Target je ein einziges tunnelförmiges Magnetfeld erstellt, welches in Targetmitte, wo das Feld parallel zum Target läuft und an der Targetoberfläche gemessen eine Magnetfeldstärke von 300 Gauss ergab.

Wie sich aus Fig. 12 ergibt, nimmt die für eine geforderte Leistung notwendige Brennspannung, ausgehend vom vorbekannten Schlitztarget (a), über eine erfindungsgemässe Anordnung nach (b) ohne Magnetfeld und schliesslich nach (c) mit Magnetfeld drastisch ab. Dies zeigt die überraschend hohe Wirkung des Insich-Schliessens der jeweiligen Zerstäubungsflächen. Im weiteren ist ersichtlich, wie sich beim Magnetfeldsputtern gemäss (c) die Kennlinie asymptotisch einem Grenzwert nähert, was für eine Magnetronkennlinie typisch ist, während sie gemäss (a) und (b) exponentiell zunehmen, was für Kathodensputtern ohne Magnetronfeld typisch ist. Tiefe Brennspannungen sind für hochqualitative dielektrische Schichten, wie für MgO, wie erwähnt, wesentlich.

Für die Erzeugung des Gasstrahles G ist es notwendig, bei für kathodisches Sputtern unüblich hohen Drücken zu arbeiten.

## Patentansprüche

1. Verfahren zum Sputterbeschichten von Werkstücken (12), bei dem zwei sich gegenüberliegende Zerstäubungsflächen (3a, 3b) gegeneinander zerstäubt werden und zwischen den Zerstäubungsflächen eine Gasströmung (G) erstellt und gegen mindestens ein Werkstück (12) gerichtet wird, dadurch gekennzeichnet, dass die sich gegenüberliegenden Zerstäubungsflächen je in sich geschlossen werden und die Gasströmung (G) durch einen in sich geschlossenen Spalt (5) im wesentlichen quer zu Schnittebenen (E) erzeugt wird, in denen der Spalt in sich geschlossen erscheint.

2. Verfahren nach Anspruch 1, dadurch gekennzeichnet, dass man die Zerstäubungsflächen (3a, 3b) je als Zerstäubungsflächen getrennter Targets (6a, 6b) ausbildet.

3. Verfahren nach einem der Ansprüche 1 oder 2, dadurch gekennzeichnet, dass man als Gasanteil ein Edelgas, wie Ar, zur Erstellung der Strömung (G) einsetzt, und für Reaktivsputtern das Reaktivgas (Gᵣ) vorzugsweise in den Werkstückbereich einlässt.

4. Verfahren nach einem der Ansprüche 1 bis 3, dadurch gekennzeichnet, dass man an mindestens einer der Zerstäubungsflächen ein Metall oder eine Metallverbindung zerstäubt.

5. Verfahren nach einem der Ansprüche 1 bis 4, dadurch gekennzeichnet, dass man die Beschichtung mit einem Material mit mindestens einer ferromagnetischen Komponente oder mit einem dielektrischen Material vornimmt.

6. Verfahren nach einem der Ansprüche 1 bis 5, dadurch gekennzeichnet, dass man die Beschichtung mit MgO oder ITO vornimmt, durch reaktives Sputtern metallischer Zerstäubungsflächen (3a, 3b) oder durch gegebenenfalls zusätzlich reaktives Sputtern oxydischer Zerstäubungsflächen.

7. Verfahren nach einem der Ansprüche 1 bis 6, dadurch gekennzeichnet, dass man von den Zerstäubungsflächen (3a, 3b) gleiche oder verschiedene Materialien sputtert.

8. Verfahren nach einem der Ansprüche 1 bis 7, dadurch gekennzeichnet, dass man im Spalt (5) ein Magnetfeld (H) erzeugt, vorzugsweise gebildet durch ein Feld an mindestens einer der Zerstäubungsflächen (3a, 3b) mit einem tunnelförmigen Feldlinienverlauf mit Tunnelachse (A_{T}) quer zur Gasströmungsrichtung (G), vorzugsweise mit je einem solchen Feld an jeder der Zerstäubungsflächen, wobei vorzugsweise der Feldlinientunnel über dem Target eine geschlossene Schleife bildet.

9. Verfahren nach Anspruch 8, dadurch gekennzeichnet, dass man im Betrieb das Magnetfeld (H) im Spalt (5) verschiebt.

10. Verfahren nach einem der Ansprüche 1 bis 9, dadurch gekennzeichnet, dass man das oder die Targets (6a, 6b) mit den Zerstäubungsflächen (3a, 3b) mit DC oder mit DC und überlagertem AC betreibt, vorzugsweise zwei getrennt vorgesehene Targets mit DC.

11. Verfahren nach einem der Ansprüche 1 bis 10, dadurch gekennzeichnet, dass man das mindestens eine Werkstück (12) potential-schwebend oder auf einem Biaspotential betreibt, dabei vorzugsweise auf einem DC-Biaspotential oder einem Biaspotential aus überlagertem DC und AC.

12. Verfahren nach einem der Ansprüche 1 bis 11, dadurch gekennzeichnet, dass man zwischen dem Spalt (5) und dem mindestens einen Werkstück (12) eine Druckstufe (10b) für die Strömung (G) erstellt.

13. Verfahren nach einem der Ansprüche 1 bis 12, dadurch gekennzeichnet, dass man die Strömung im knudsenschen oder im viskosen Bereich im Spalt (5) realisiert, vorzugsweise im knudsenschen Bereich.

14. Verfahren nach einem der Ansprüche 1 bis 13, dadurch gekennzeichnet, dass man die Zerstäubungsflächen (3a, 3b) äquidistant oder mit sich gegen das Werkstück (12) hin verjüngendem Abstand anordnet.

15. Sputterbeschichtungsquelle mit zwei sich gegenüberliegenden Zerstäubungsflächen (3a, 3b), einer zwischen den Zerstäubungsflächen vorhandenen Anodenanordnung (8) und einer in einem zwischen den Zerstäubungsflächen definierten Spalt (5) wirkenden Gasauslassanordnung (38), dadurch gekennzeichnet, dass die Zerstäubungsflächen (3a, 3b) je in sich geschlossene Flächen bilden, der Spalt (5) ein sich geschlossener, mindestens einseitig offener Spalt ist und die Gasauslassanordnung der Spaltöffnung (10) gegenüberliegend angeordnet ist.

16. Quelle nach Anspruch 15, dadurch gekennzeichnet, dass die Zerstäubungsflächen je durch ein Target (6a, 6b) gebildet sind und diese gemeinsam oder vorzugsweise getrennt mit Anschlüssen für Speisequellen (14a - 14c) versehen sind.

17. Quelle nach einem der Ansprüche 15 oder 16, dadurch gekennzeichnet, dass mindestens eine der Zerstäubungsflächen eine Metallfläche ist oder eine Metallverbindungsfläche, vorzugsweise eine Mg- bzw. MgO-Fläche oder eine In-Sn- bzw. ITO-Fläche und dass weiter bevorzugterweise beide Zerstäubungsflächen aus gleichem Material bestehen.

18. Quelle nach einem der Ansprüche 15 bis 17, dadurch gekennzeichnet, dass mindestens eine der Zerstäubungsflächen, vorzugsweise beide, aus ferromagnetischem Material, wie z.B. aus Fe, besteht.

19. Quelle nach einem der Ansprüche 15 bis 18, dadurch gekennzeichnet, dass eine Permanent- und/oder Elektromagnetanordnung (44) vorhanden ist, welche im Spalt (5) ein Magnetfeld (H) erzeugt.

20. Quelle nach Anspruch 19, dadurch gekennzeichnet, dass die Magnetanordnung (44) über mindestens einer der Zerstäubungsflächen, vorzugsweise über beiden, ein Tunnelfeld erzeugt mit einer entlang der Spaltöffnung (10) verlaufenden Tunnelachse (A_{T}).

21. Quelle nach einem der Ansprüche 19 oder 20, dadurch gekennzeichnet, dass die Magnetanordnung (44) relativ zu mindestens einer der Zerstäubungsflächen (3a, 3b) verschiebliche Magnete umfasst.

22. Quelle nach einem der Ansprüche 15 bis 21, dadurch gekennzeichnet, dass der Spalt (5) einseitig geschlossen (36) ist und in diesem Bereich die Anodenanordnung (34) vorhanden ist.

23. Quelle nach einem der Ansprüche 15 bis 22, dadurch gekennzeichnet, dass die Spaltöffnung (10) durch eine in sich geschlossene, umlaufende Schlitzblende (10b) gebildet ist.

24. Sputterbeschichtungsanlage mit mindestens einer Quelle nach einem der Ansprüche 15 bis 23 in einer Vakuumkammer, dadurch gekennzeichnet, dass das oder die die Zerstäubungsflächen bildenden Targets (6a, 6b) mit einem DC-Generator (14a - 14c) oder mit einem Generator zur Abgabe von DC und überlagertem AC, insbesondere gepulstem DC, verbunden sind, vorzugsweise zwei die Sputterflächen definierende Targets je mit einem gleichartigen Generator.

25. Anlage nach Anspruch 24, dadurch gekennzeichnet, dass eine weitere Gasauslassanordnung in die Vakuumkammer mit einem Reaktivgasvorrat (43), vorzugsweise mit O₂, verbunden ist.

26. Verwendung des Verfahrens bzw. der Quelle bzw. der Anlage nach einem der Ansprüche 1-25 für die Beschichtung mindestens eines Werkstückes mit einem ein ferromagnetisches Material enthaltenden Material oder mit einem dielektrischen Material.

27. Verwendung des Verfahrens bzw. der Quelle bzw. der Anlage nach einem der Ansprüche 1-25 für die Beschichtung mindestens eines Werkstückes mit einer MgO- oder ITO-Schicht.

28. Verwendung des Verfahrens bzw. der Quelle bzw. der Anlage nach einem der Ansprüche 1-25 für die Beschichtung von Plasma Display Panels.

## Claims

1. Process for sputter coating of workpieces (12) in which two opposing sputtering surfaces (3a, 3b) are sputtered against each other and a gas flow (G) produced between the sputtering surfaces and targeted towards at least one workpiece (12),
characterised in that the opposing sputtering surfaces are closed in themselves and the gas flow (G) is produced through a gap (5) closed in itself essentially transverse to the section plane (E) in which the gap appears closed in itself.

2. Process according to claim 1, characterised in that the sputtering surfaces (3a, 3b) are each formed as sputtering surfaces of separate targets (6a, 6b).

3. Process according to any of claims 1 or 2, characterised in that an inert gas such as Ar is used as a proportion of the gas to generate the flow (G) and for reactive sputtering the reactive gas (Gᵣ) is preferably introduced into the workpiece area.

4. Process according to any of claims 1 to 3, characterised in that a metal or a metal compound is sputtered on at least one of the sputtering surfaces.

5. Process according to any of claims 1 to 4, characterised in that the coating takes place with a material with at least one ferromagnetic component or with a dielectric material.

6. Process according to any of claims 1 to 5, characterised in that the coating is carried out with MgO or ITO by reactive sputtering of metal sputtering surfaces (3a, 3b) or of oxidic sputtering surfaces, where applicable by additional reactive sputtering.

7. Process according to any of claims 1 to 6, characterised in that the same or different materials are sputtered from the sputtering surfaces (3a, 3b).

8. Process according to any of claims 1 to 7, characterised in that in the gap (5) is generated a magnetic field (H), preferably formed by a field on at least one of the sputtering surfaces (3a, 3b) with a tunnel-shaped flux line path with a tunnel axis (A_{T}) transverse to the direction of gas flow (G), preferably with one such field at each of the sputtering surfaces where preferably the flux line tunnel forms a closed loop over the target.

9. Process according to claim 8, characterised in that in operation the magnetic field (H) shifts in the gap (5).

10. Process according to any of claims 1 to 9, characterised in that the target or targets (6a, 6b) with sputtering surfaces (3a, 3b) are operated with DC or with DC and superposed AC, preferably two separate targets with DC.

11. Process according to any of claims 1 to 10, characterised in that the at least one workpiece (12) is operated potential-floating or to a bias potential, here preferably to a DC bias potential or a bias potential of superposed DC and AC.

12. Process according to any of claims 1 to 11, characterised in that between the gap (5) and the at least one workpiece (12) is generated a pressure stage (10b) for the flow (G).

13. Process according to any of claims 1 to 12, characterised in that the flow is produced in the gap (5) in the Knudsen or the viscous range, preferably in the Knudsen range.

14. Process according to any of claims 1 to 13, characterised in that the sputtering surfaces (3a, 3b) are arranged equidistant or with an interval which tapers towards the workpiece (12).

15. Sputter coating source with two opposing sputtering surfaces (3a, 3b), an anode arrangement (8) present between the sputtering surfaces and a gas outlet device (38) acting in a gap (5) defined between the sputtering surfaces, characterised in that the sputtering surfaces (3a, 3b) form surfaces closed in themselves, the gap (5) is a gap closed in itself and open on at least one side, and the gas outlet device is arranged opposite the gap opening (10).

16. Source according to claim 15, characterised in that the sputtering surfaces are each formed by a target (6a, 6b) and these are jointly or preferably separately provided with connections for power sources (14a - 14c).

17. Source according to any of claims 15 or 16, characterised in that at least one of the sputtering surfaces is a metal surface or a metal compound surface, preferably an Mg or MgO surface or an In-Sn or ITO surface and that also preferably both sputtering surfaces consist of the same material.

18. Source according to any of claims 15 to 17, characterised in that at least one of the sputtering surfaces, preferably both, consists of ferromagnetic material e.g. Fe.

19. Source according to any of claims 15 to 18, characterised in that a permanent magnet and/or electromagnet arrangement (44) is present which generates a magnetic field (H) in the gap (5).

20. Source according to claim 19, characterised in that the magnetic arrangement (44) generates a tunnel field over at least one of the sputtering surfaces, preferably over both, with a tunnel axis (A_{T}) running along the gap opening (10).

21. Source according to any of claims 19 or 20, characterised in that the magnet arrangement (44) comprises magnets displaceable relative to at least one of the sputtering surfaces (3a, 3b).

22. Source according to any of claims 15 to 21, characterised in that the gap (5) is closed on one side (36) and the anode arrangement (34) is present in this area.

23. Source according to any of claims 15 to 22, characterised in that the gap opening (10) is formed by a peripheral slit diaphragm (10b) closed in itself.

24. Sputter coating device with at least one source according to any of claims 15 to 23 in a vacuum chamber, characterised in that the targets (6a, 6b) forming the sputtering surfaces are connected to a DC generator (14a, 14c) or a generator to emit DC and superposed AC, in particular pulsed DC, preferably two targets defining the sputter surfaces each with a generator of the same type.

25. Device according to claim 24, characterised in that a further gas outlet arrangement into the vaccum chamber is connected with a reactive gas store (43), preferably containing O₂.

26. Use of the process or source or device according to any of claims 1 to 25 for coating at least one workpiece with a material containing a ferromagnetic material or with a dielectric material.

27. Use of the process or source or device according to any of claims 1 to 25 for coating at least one workpiece with an MgO or ITO coating.

28. Use of the process or source or device according to any of claims 1 to 25 for coating plasma display panels.

## Revendications

1. Procédé pour l'application d'un revêtement par pulvérisation cathodique sur des pièces (12), selon lequel des surfaces de pulvérisation opposées (3a, 3b) sont pulvérisées l'une en face de l'autre et un écoulement de gaz (G) est formé entre ces deux surfaces et est dirigé vers au moins une pièce (12), caractérisé en ce que chacune des surfaces de pulvérisation opposées est continue et l'écoulement de gaz (G) est généré à travers un interstice continu (5), globalement perpendiculairement à des plans de coupe (E) dans lesquels l'interstice apparaît continu

2. Procédé selon la revendication 1, caractérisé en ce que les surfaces de pulvérisation (3a, 3b) sont conçues comme des surfaces de pulvérisation de cibles séparées (6a, 6b).

3. Procédé selon la revendication 1 ou 2, caractérisé en ce qu'une partie du gaz utilisé est constituée par un gaz rare comme Ar pour former l'écoulement (G), et pour la pulvérisation réactive, on introduit le gaz réactif (Gᵣ) de préférence dans la zone des pièces.

4. Procédé selon l'une des revendications 1 à 3, caractérisé en ce qu'on pulvérise sur l'une au moins des surfaces de pulvérisation un métal ou un composé métallique.

5. Procédé selon l'une des revendications 1 à 4, caractérisé en ce qu'on effectue l'application de revêtement avec un matériau contenant au moins un composant ferromagnétique, ou avec un matériau diélectrique.

6. Procédé selon l'une des revendications 1 à 5, caractérisé en ce qu'on effectue l'application de revêtement avec MgO ou ITO, par pulvérisation réactive de surfaces de pulvérisation métalliques (3a, 3b) ou éventuellement par pulvérisation réactive supplémentaire de surfaces de pulvérisation en oxyde.

7. Procédé selon l'une des revendications 1 à 6, caractérisé en ce qu'on soumet à la pulvérisation cathodique des matériaux identiques aux surfaces de pulvérisation (3a, 3b) ou différents de celles-ci.

8. Procédé selon l'une des revendications 1 à 7, caractérisé en ce qu'on génère dans l'interstice (5) un champ magnétique (H) formé de préférence par un champ sur l'une au moins des surfaces de pulvérisation (3a, 3b) avec un tracé de lignes de champ en forme de tunnel dont l'axe de tunnel (A_{T}) est perpendiculaire au sens d'écoulement de gaz (G), de préférence avec un champ de ce type sur chacune des surfaces de pulvérisation, le tunnel de lignes de champ définissant une boucle fermée sur la cible.

9. Procédé selon la revendication 8, caractérisé en ce qu'on déplace le champ magnétique (H) dans l'interstice (5), en fonctionnement.

10. Procédé selon l'une des revendications 1 à 9, caractérisé en ce qu'on fait fonctionner la ou les cibles (6a, 6b) avec les surfaces de pulvérisation (3a, 3b) avec un courant continu ou avec un courant continu et un courant alternatif superposé, et on fait fonctionner de préférence deux cibles distinctes avec un courant continu.

11. Procédé selon l'une des revendications 1 à 10, caractérisé en ce qu'on fait fonctionner la ou les pièces (12) à un potentiel flottant ou à un potentiel de polarisation, et de préférence à un potentiel de polarisation à courant continu ou à un potentiel de polarisation composé de courant continu et de courant alternatif superposés.

12. Procédé selon l'une des revendications 1 à 11, caractérisé en ce qu'on forme entre l'interstice (5) et la ou les pièces (12) un étage de pression (10b) pour l'écoulement (G).

13. Procédé selon l'une des revendications 1 à 12, caractérisé en ce qu'on réalise l'écoulement dans la zone de régime intermédiaire ou dans la zone visqueuse, dans l'interstice (5), et de préférence dans la zone de régime intermédiaire.

14. Procédé selon l'une des revendications 1 à 13, caractérisé en ce qu'on dispose les surfaces de pulvérisation (3a, 3b) à la même distance l'une de l'autre ou à une distance qui va en diminuant vers la pièce (12).

15. Source d'application de revêtement par pulvérisation cathodique comportant deux surfaces de pulvérisation opposées (3a, 3b), un dispositif formant anode (8) qui est prévu entre celles-ci et un dispositif de sortie de gaz (38) qui agit dans un interstice (5) défini entre les surfaces de pulvérisation, caractérisée en ce que les surfaces de pulvérisation (3a, 3b) forment chacune une surface continue, l'interstice (5) est constitué par un interstice continu ouvert au moins d'un côté et le dispositif de sortie de gaz est disposé à l'opposé de l'ouverture d'interstice (10).

16. Source selon la revendication 15, caractérisée en ce que les surfaces de pulvérisation sont définies par des cibles respectives (6a, 6b) et celles-ci sont pourvues conjointement ou de préférence séparément de raccordements pour des sources d'alimentation (14a-14c).

17. Source selon la revendication 15 ou 16, caractérisée en ce que l'une au moins des surfaces de pulvérisation est une surface métallique ou une surface formée d'un composé métallique, de préférence une surface de Mg ou MgO, ou une surface In-Sn ou ITO, et en ce que les deux surfaces de pulvérisation, de préférence, se composent d'un même matériau.

18. Source selon l'une des revendications 15 à 17, caractérisée en ce que l'une au moins des surfaces de pulvérisation et de préférence les deux se composent d'un matériau ferromagnétique, par exemple Fe.

19. Source selon l'une des revendications 15 à 18, caractérisée en ce qu'il est prévu un dispositif formant aimant permanent et/ou électro-aimant (44) qui génère un champ magnétique (H) dans l'interstice (5).

20. Source selon la revendication 19, caractérisée en ce que le dispositif formant aimant (44) génère sur l'une au moins des surfaces de pulvérisation, de préférence sur les deux, un champ en forme de tunnel avec un axe de tunnel (A_{T}) qui s'étend le long de l'ouverture d'interstice (10).

21. Source selon la revendication 19 ou 20, caractérisée en ce que le dispositif formant aimant (44) comporte des aimants qui sont mobiles par rapport à l'une au moins des surfaces de pulvérisation (3a, 3b).

22. Source selon l'une des revendications 15 à 21, caractérisée en ce que l'interstice (5) est fermé (36) d'un côté, et le dispositif formant anode (34) est prévu dans cette zone.

23. Source selon l'une des revendications 15 à 22, caractérisée en ce que l'ouverture d'interstice (10) est définie par un obturateur à fente (10b) continu et circulaire.

24. Installation d'application de revêtement par pulvérisation cathodique comportant au moins une source selon l'une des revendications 15 à 23 dans une chambre à vide, caractérisée en ce que la ou les cibles (6a, 6b) qui définissent les surfaces de pulvérisation sont reliées à un générateur de courant continu (14a-14c) ou à un générateur pour fournir un courant continu et un courant alternatif superposé, en particulier un courant continu pulsé, et de préférence deux cibles définissant les surfaces de pulvérisation cathodique sont reliées à deux générateurs respectifs de même type.

25. Installation selon la revendication 24, caractérisée en ce qu'un autre dispositif de sortie de gaz prévu dans la chambre à vide est relié à une réserve de gaz réactif (43), de préférence O₂.

26. Utilisation du procédé ou de la source ou de l'installation selon l'une des revendications 1 à 25, pour appliquer sur au moins une pièce un matériau contenant un matériau ferromagnétique, ou un matériau diélectrique.

27. Utilisation du procédé ou de la source ou de l'installation selon l'une des revendications 1 à 25, pour appliquer sur au moins une pièce une couche de MgO ou ITO.

28. Utilisation du procédé ou de la source ou de l'installation selon l'une des revendications 1 à 25 pour revêtir des panneaux d'affichage à plasma.
